# EUROPEAN PATENT APPLICATION

(11) **EP 4 186 706 A1**
(43) Date of publication of application: **31.05.2023**
(21) Application number: 21845806.5
(22) Date of filing: 18.06.2021
(51) Int. Cl.: B41J 2/175

(54) **CIRCUIT BOARD AND PRODUCTION METHOD THEREFOR, CIRCUIT DEVICE AND PRODUCTION METHOD THEREFOR, AND PRINTING MATERIAL CONTAINER ASSEMBLY**

(30) Priority: 23.07.2020 CN 202010719540
(71) Applicant: Hangzhou Chipjet Technology Co., Ltd., Binjiang District Hangzhou Zhejiang 310052 (CN)
(72) Inventor: LUO, Shan, Hangzhou, Zhejiang 310052 (CN); PENG, Xiaogai, Hangzhou, Zhejiang 310052 (CN); MA, Xiaojing, Hangzhou, Zhejiang 310052 (CN)
(74) Representative: Gill Jennings & Every LLP
(86) International application number: PCT/CN2021/100790
(87) International publication number: WO 2022/017092

(57) **Abstract**

Provided are a circuit board and production method therefor, a circuit device and production method therefor, and a printing material container assembly. The circuit board is mounted on a printing material container. The circuit board includes an original circuit board and an auxiliary part. The original circuit board includes multiple terminals configured to be in contact with the printing material container or a printing device. The auxiliary part is disposed on the original circuit board and is configured to perform at least one of the following: providing a conductive path or breaking off a conductive path between the terminals.

## Description

This application claims priority to Chinese Patent Application No. 202010719540.0 filed with the China National Intellectual Property Administration (CNIPA) on July 23, 2020, the disclosure of which is incorporated herein by reference in its entirety.

### TECHNICAL FIELD

The present application relates to the field of circuit boards, for example, a circuit board and production method therefor, a circuit device and production method therefor, and a printing material container assembly.

### BACKGROUND

Printing devices are widely used in modem society. A printing device includes a printing material container on which a circuit board and a chip corresponding to the printing device are disposed. With the popularization of printing devices, increasingly high requirements are imposed on the cost of a printing device.

One way to reduce the cost of a printing device is to recycle the printing material container. For example, a printing material container of the original series is recycled and then applied to a printing device of the target series. However, both recycled printing material containers and circuit boards on the recycled printing material containers are diverse, so when applied to a printing device of the target series, a circuit board on a recycled printing material container may be incompatible with the printing device of the target series. As a result, the circuit board on the recycled printing material container cannot be applied to the printing device of the target series, and thus the cost of the printing device cannot be reduced.

### SUMMARY

The present application provides a circuit board and production method therefor, a circuit device and production method therefor, and a printing material container assembly so that a circuit board of a printing device of the original series is applicable to a printing device of the target series, and thus the cost of the printing device can be reduced.

A circuit board is provided. The circuit board is mounted on a printing material container. The circuit board includes an original circuit board and an auxiliary part. The original circuit board includes multiple terminals configured to be in contact with the printing material container or a printing device. The auxiliary part is disposed on the original circuit board and is configured to perform at least one of the following: providing a conductive path or breaking off a conductive path between the terminals.

A circuit device is also provided. The circuit device includes the preceding circuit board and a chip. The chip includes a control unit and a memory. A plurality of pins of the chip are correspondingly bonded to the terminals of the circuit board.

A printing material container assembly is also provided. The printing material container assembly includes a printing material container and the preceding circuit device. The printing material container is removably connected to the circuit device.

A production method for a circuit board is also provided. The method includes providing an original circuit board, where the original circuit board includes a plurality of terminals configured to be in contact with a printing material container or a printing device; and producing an auxiliary part on the original circuit board, where the auxiliary part is configured to perform at least one of the following: providing a conductive path or breaking off a conductive path between the terminals.

A production method for a circuit device is also provided. The method is configured to produce the preceding circuit device. The method includes removing an original chip from an original circuit device to obtain the original circuit board; and bonding the chip to the original circuit board.

### BRIEF DESCRIPTION OF DRAWINGS

FIG. 1 is a structure diagram illustrating the contact surface of a printing material container of a circuit board according to an embodiment of the present application.
FIG. 2 is a circuit diagram illustrating electrical connection of a circuit board, a printing device, and a chip according to an embodiment of the present application.
FIG. 3 is a structure diagram illustrating the contact surface of a printing device of a circuit board according to an embodiment of the present application.
FIG. 4 is a structure diagram illustrating the contact surface of a printing device of another circuit board according to an embodiment of the present application.
FIG. 5 is a structure diagram illustrating the contact surface of a printing device of another circuit board according to an embodiment of the present application.
FIG. 6 is a circuit diagram of a circuit device according to an embodiment of the present application.
FIG. 7 is a flowchart of a production method for a circuit board according to an embodiment of the present application.
FIG. 8 is a flowchart of a production method for a circuit device according to an embodiment of the present application.

### DETAILED DESCRIPTION

The present application is described hereinafter in conjunction with drawings and embodiments.

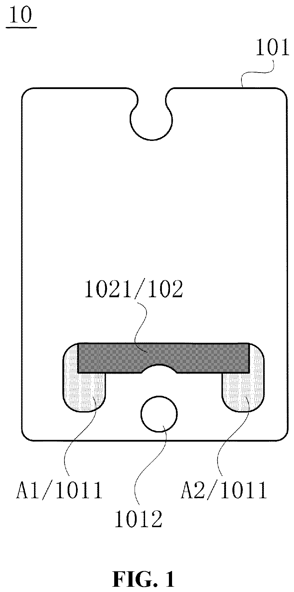

FIG. 1 is a structure diagram illustrating the contact surface of a printing material container of a circuit board according to an embodiment of the present application. With reference to FIG. 1, the circuit board 10 is mounted on a printing material container, and the circuit board 10 includes an original circuit board 101 and an auxiliary part 102. The original circuit board 101 includes multiple terminals 1011 configured to be in contact with the printing material container or a printing device. The auxiliary part 102 is disposed on the original circuit board 101 and is configured to perform at least one of the following: providing a conductive path or breaking off a conductive path between the terminals 1011.

The printing device may be, for example, an inkjet printer. The printing device has a printing material container (ink cartridge) and a circuit board corresponding to the printing material container. The printing device is configured to identify the remaining amount (the remaining ink level) of the printing material in the printing material container through the circuit board. The printing device includes multiple chip-side terminals configured to be in contact with corresponding terminals on the circuit board so as to realize an electrical connection between the printing device and the circuit board. The ink cartridge may include a sensor configured to detect the remaining ink level in the ink cartridge. The sensor includes a chip-side terminal configured to be in contact with corresponding terminals on the circuit board so as to realize an electrical connection between the sensor and the circuit board. When the circuit board is mounted on the ink cartridge, the chip-side terminal on the ink cartridge is electrically connected to a corresponding terminal on the circuit board to realize an electrical connection between the circuit board and the ink cartridge. When the ink cartridge and the circuit board are mounted in the printing device, the chip-side terminals on the printing device are in contact with the corresponding terminals on the circuit board so as to realize an electrical connection between the the printing device and the circuit board. In this manner, the main controller in the printing device can acquire information about the ink cartridge through the circuit board, such as the remaining ink level in the ink cartridge, so that the printing device can perform a corresponding operation according to the remaining ink level. The circuit board may be, for example, a printed circuit board (PCB). The printed circuit board may be a single-layer or multi-layer structure. A terminal on the printed circuit board may be, for example, a pad.

The connection between multiple terminals on the circuit board in a printing device of the original series may be different from the connection between multiple terminals on the circuit board in a printing device of the target series. For example, no conductive path exists between two terminals on the original circuit board while a conductive path is required between two corresponding terminals on the circuit board in the printing device of the target series. After the circuit board in the printing device of the original series (the original circuit board) is recycled, the original circuit board may be modified according to the structure of the circuit board in the printing device of the target series. For example, the auxiliary part is produced on the original circuit board so that a conductive path exists between two corresponding terminals on the obtained new circuit board, and thus the printing device of the target series can recognize the circuit board made from the original circuit board. For another example, a conductive path exists between two terminals on the original circuit board while no conductive path can exist between two corresponding terminals on the circuit board in the printing device of the target series; in this case, the conductive path on the original circuit board may be broken off by using the auxiliary part so that the printing device of the target series can recognize the circuit board made from the original circuit board, that is, cross-generation utilization of the original circuit board is achieved. In this manner, the recycling rate of the original circuit board can be greatly improved so that the cost of the circuit board in the printing device can be reduced, and thus the cost of the printing device can be reduced.

The printing device of the original series may in an old series or a new series relative to the printing device of the target series. This is not limited in this embodiment of the present application.

In the solution of this embodiment, the circuit board includes the original circuit board and the auxiliary part. The original circuit board includes multiple terminals configured to be in contact with the printing material container or the printing device. The auxiliary part is disposed on the original circuit board and is configured to perform at least one of the following: providing a conductive path or breaking off a conductive path between the terminals. The original circuit board may be modified according to the structure of the circuit board in the printing device of the target series. For example, the auxiliary part is produced on the original circuit board so that a conductive path exists between two corresponding terminals on the new circuit board and/or a conductive path between two corresponding terminals on the new circuit board is broken off, and thus the printing device of the target series can recognize the circuit board made from the original circuit board, that is, cross-generation utilization of the original circuit board is achieved. In this manner, the recycling rate of the original circuit board can be greatly improved so that the cost of the circuit board in the printing device can be reduced, and thus the cost of the printing device can be reduced.

Optionally, the auxiliary part is configured to provide a conductive path, and the auxiliary part is resistive.

In the original circuit board of the printing device of the original series, no conductive path exists between two terminals. Whereas, in the circuit board of the printing device of the target series, in order for the circuit board of the printing device of the target series to be recognized by the printing device of the target series, not only is a conductive path required between two corresponding terminals but also a resistor is required between the two corresponding terminals. Therefore, the auxiliary part may be configured to be resistive so that the original circuit board added with the auxiliary part is applicable to the printing device of the target series.

Optionally, the auxiliary part includes carbon oil or a resistive discrete component.

Both the carbon oil and the resistive discrete component make it possible to form a conductive path between two corresponding terminals. When the auxiliary part is configured to provide a conductive path, the auxiliary part may be the carbon oil. The carbon oil can be easily coated on the original circuit board. The carbon oil is small in thickness and occupies a small space, not affecting the space occupied by the circuit board, that is, not making the circuit board change too greatly in size to match the ink cartridge or the printing device. Moreover, it is feasible to control the resistance value of the carbon oil according to the size of the carbon oil and thus to control the resistance value between corresponding terminals on the circuit board so that the printing device of the target series can recognize the circuit board made from the original circuit board.

Optionally, the auxiliary part is carbon oil, and the circuit board also includes an insulating film covering at least part of the auxiliary part.

When the auxiliary part is carbon oil, and the carbon oil is thin, a breakpoint may exist in the carbon oil subjected to long-time abrasion or water-oxygen corrosion, and the conductive path may be broken off. As a result, the corresponding printing device cannot recognize the circuit board. With providing the insulating film, when the carbon oil serves as only a conductive path between two terminals, the insulating film may completely cover the carbon oil; when the carbon oil also serves as a terminal (that is, the carbon oil is required to be in contact with the printing material container or a corresponding chip-side terminal on the printing device so as to realize an electrical connection between the circuit board and the printing material container or an electrical connection between the circuit board and the printing device), the insulating film may cover a portion of the carbon oil which does not serve as a terminal, to prevent the carbon oil from being damaged by abrasion or water-oxygen corrosion, thereby greatly prolonging the service life of the circuit board.

Optionally, with continued reference to FIG. 1, the original circuit board 101 includes a first sensor connection terminal A1 and a second sensor connection terminal A2. The first sensor connection terminal A1 and the second sensor connection terminal A2 are each configured to be in contact with the printing material container. The auxiliary part includes a first auxiliary part 1021. The first auxiliary part 1021 is connected to the first sensor connection terminal A1 and the second sensor connection terminal A2 and is configured to provide a conductive path between the first sensor connection terminal A1 and the second sensor connection terminal A2.

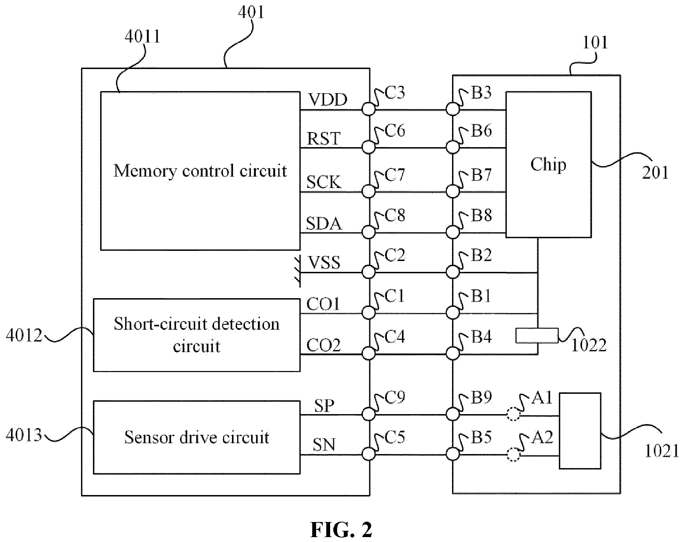

FIG. 2 is a circuit diagram illustrating electrical connection of a circuit board, a printing device, and a chip according to an embodiment of the present application. See FIGS. 1 and 2. The first sensor connection terminal A1 and the second sensor connection terminal A2 are each configured to be connected to the sensor. The printing device includes a device-side circuit 401 and a chip-side terminal (to be described below). The original circuit board 101 may be, for example, a circuit board of a printing device of the original series. There may be no conductive path between the first sensor connection terminal A1 and the second sensor connection terminal A2 on the original circuit board 101. In contrast, a conductive path is required between the first sensor connection terminal A1 and the second sensor connection terminal A2 corresponding to the circuit board in the printing device of the target series. Thus, the first auxiliary part 1021 may be configured to make the first sensor connection terminal A1 electrically connected to the second sensor connection terminal A2. For example, the resistance value of the first auxiliary part 1021 conforms to the resistance value between the corresponding terminals on the circuit board in the printing device of the target series so that the original circuit board 101 is compatible with the printing device of the target series after the first auxiliary part 1021 is added. In this manner, the original circuit board 101 is reused. Thus, the overall cost of the printing device is reduced. In this embodiment of the present application, the shape of the first auxiliary part 1012 is not limited as long as the resistance value of the first auxiliary part 1012 satisfies the requirements. The first auxiliary part 1012 may completely or partially cover the first sensor connection terminal A1 and the second sensor connection terminal A2 such that the first auxiliary part 1012 has a large contact area with the first sensor connection terminal A1 and the second sensor connection terminal A2 so as to improve the contact performance and prevent a poor contact.

Optionally, with continued reference to FIG. 1, the original circuit board 101 also includes a stop hole 1012 between the first sensor connection terminal A1 and the second sensor connection terminal A2. The minimum distance between the edge of the first auxiliary part 1021 and the edge of the stop hole 1012 is greater than or equal to a preset distance.

The stop hole 1012 may be configured to secure the circuit board 10 to the printing material container. The stop hole 1012 may be circular or rectangular or may be in other shapes. The minimum distance between the edge of the first auxiliary part 1021 and the edge of the stop hole 1012 may be set to be greater than or equal to a preset distance to prevent an excessively small distance between the edge of the first auxiliary part 1021 (carbon oil) and the edge of the stop hole 1012, thereby preventing the proneness to abrasive wear or preventing a waste of carbon oil caused by carbon oil prepared in the region of the stop hole 1012 due to the excessively small distance.

Optionally, the auxiliary part is configured to provide a conductive path.

In the original circuit board of the printing device of the original series, there is no conductive path between two terminals. In contrast, in the original circuit board of the printing device of the target series, there is a conductive path between two corresponding terminals, and there is no resistor between the two corresponding terminals. Therefore, the auxiliary part may be configured to provide only a conductive path and may be configured to be non-resistive so that the original circuit board can be recognized by the printing device of the target series after the auxiliary part is added. The non-resistance of the auxiliary part does not mean that the resistance of the auxiliary part must be zero, but means that the impedance of the auxiliary part is small, and the voltage drop at two ends of the auxiliary part is within the error range corresponding to the printing device, so that the original circuit board of the printing device of the original series can be recognized by the printing device after the auxiliary part is configured.

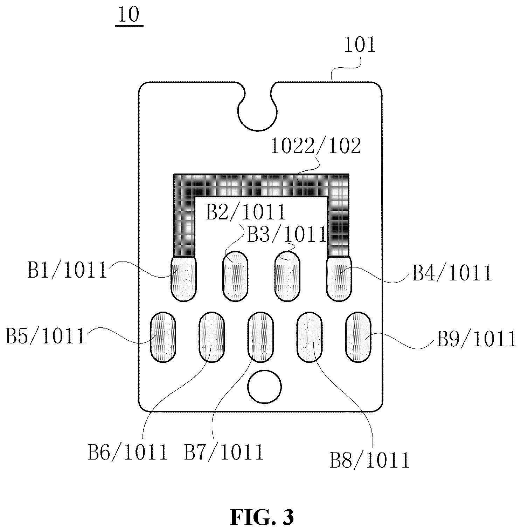

Optionally, FIG. 3 is a structure diagram illustrating the contact surface of a printing device of a circuit board according to an embodiment of the present application. This structure may correspond to the circuit board shown in FIG. 1. See FIGS. 1 to 3. The original circuit board includes a first short-circuit detection terminal B1 and a second short-circuit detection terminal B4. The first short-circuit detection terminal B1 and the second short-circuit detection terminal B4 are each configured to be in contact with the printing device. The auxiliary part 102 includes a second auxiliary part 1022. The second auxiliary part 1022 is connected to the first short-circuit detection terminal B1 and the second short-circuit detection terminal B4 and is configured to provide a conductive path between the first short-circuit detection terminal B1 and the second short-circuit detection terminal B4.

See FIGS. 1 to 3. The original circuit board 101 may include a first short-circuit detection terminal B1, a ground terminal B2, a power terminal B3, a second short-circuit detection terminal B4, a first sensor drive terminal B5, a reset terminal B6, a clock terminal B7, a data terminal B8, and a second sensor drive terminal B9. The first short-circuit detection terminal B1, the ground terminal B2, the power terminal B3, and the second short-circuit detection terminal B4 are located in the upper row. The first sensor drive terminal B5, the reset terminal B6, the clock terminal B7, the data terminal B8, and the second sensor drive terminal B9 are located in the lower row. The printing device includes a device-side circuit 401. The device-side circuit 401 may include a memory control circuit 4011, a short-circuit detection circuit 4012, and a sensor drive circuit 4013. The device-side circuit 401 is connected to the first short-circuit detection terminal B1, the ground terminal B2, the power terminal B3, the second short-circuit detection terminal B4, the first sensor drive terminal B5, the reset terminal B6, the clock terminal B7, the data terminal B8, and the second sensor drive terminal B9 through the corresponding chip-side terminals (a first chip-side terminal C1, a second chip-side terminal C2, a third chip-side terminal C3, a fourth chip-side terminal C4, a fifth chip-side terminal C5, a sixth chip-side terminal C6, a seventh chip-side terminal C7, an eighth chip-side terminal C8, and a ninth chip-side terminal C9) respectively. The ground terminal B2, the power terminal B3, the reset terminal B6, the clock terminal B7, and the data terminal B8 are connected to a chip 201. The chip 201 may include a memory. The ground terminal B2 is grounded by the second chip-side terminal C2 on the printing device. The memory control circuit 4011 transmits a power signal VDD, a reset signal RST, a clock signal SCK, and a data signal SDA to the chip 201 through corresponding terminals. The short-circuit detection circuit 4012 transmits short-circuit detection signals CO1 and CO2 to the chip 201 through the first short-circuit detection terminal B1 and the second short-circuit detection terminal B4. The sensor drive circuit 4013 transmits drive signals (SP and SN) to the sensor through the first sensor drive terminal B5, the second sensor drive terminal B9, the first sensor connection terminal A1, and the second sensor connection terminal A2. In the circuit board of the printing device of the original series, there may be no conductive path between the first short-circuit detection terminal B1 and the second short-circuit detection terminal B4. In contrast, a conductive path is required between the first short-circuit detection terminal B1 and the second short-circuit detection terminal B4 corresponding to the printing device of the target series. In this embodiment, the second auxiliary part 1022 is configured to provide a conductive path between the first short-circuit detection terminal B1 and the second short-circuit detection terminal B2 so that the original circuit board 101 is applicable to the printing device of the target series. In this manner, cross-generation utilization of the original circuit board 101 is achieved. Thus, the recycling rate of the original circuit board 101 is greatly improved so that the cost of the circuit board in the printing device is reduced, thereby the cost of the printing device being reduced. The second auxiliary part 1022 may be carbon oil. The shape of the second auxiliary part 1022 is not limited so that the original circuit board 101 is compatible with the printing device of the target series after the second auxiliary part 1022 is added.

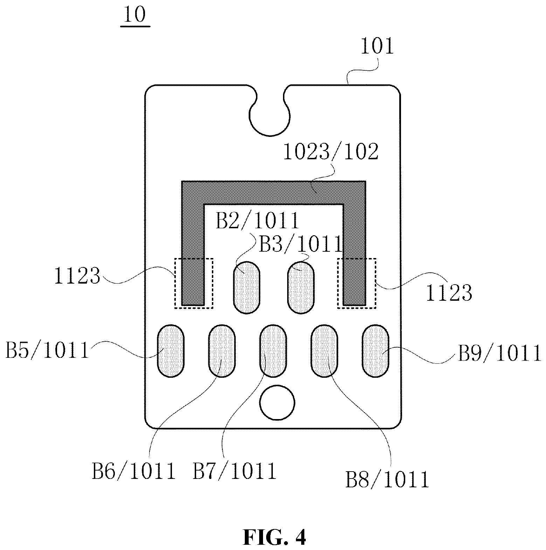

Optionally, FIG. 4 is a structure diagram illustrating the contact surface of a printing device of another circuit board according to an embodiment of the present application. Referring to FIG. 4, unlike the circuit board shown in FIG. 3, the original circuit board 101 of FIG. 4 does not include terminals (corresponding to the first short-circuit detection terminal B1 and the second short-circuit detection terminal B4 of FIG. 3) configured to be electrically connected to the circuit detection circuit in the printing device, the auxiliary part 102 includes a third auxiliary part 1023, and the third auxiliary part 1023 includes a contact part 1123 configured to be electrically connected to the short-circuit detection circuit.

In the circuit board of the printing device of the original series, there may be no first short-circuit detection terminal and second short-circuit detection terminal. In contrast, in this embodiment, the device-side circuit of the printing device of the target series includes a short-circuit detection circuit (as shown in FIG. 2). If the circuit board of the printing device of the original series (the original circuit board) is applied to the printing device of the target series, the printing device of the target series may be abnormal because the short-circuit detection cannot be performed, that is, the original circuit board is not compatible with the printing device of the target series.

Referring to FIG. 4, the contact part 1123 of the third auxiliary part 1023 may be reused as a terminal, that is, the contact part 1123 on the third auxiliary part 1023 is in contact with a terminal corresponding to the short-circuit detection circuit 4012 in the printing device, so that the original circuit board 101 is applicable to the printing device of the target series.

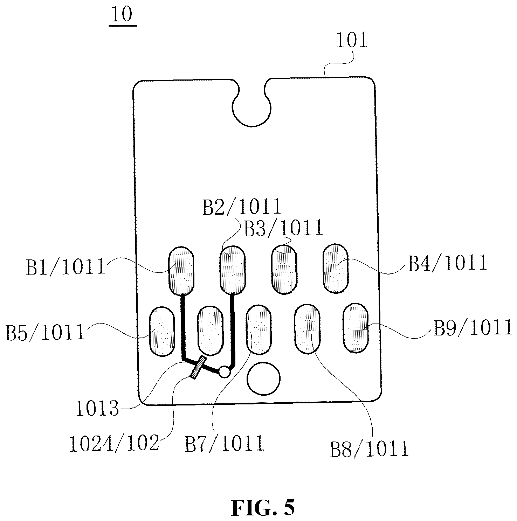

Optionally, FIG. 5 is a structure diagram illustrating the contact surface of a printing device of another circuit board according to an embodiment of the present application. See FIG. 5. The auxiliary part 102 includes a groove configured to break off the conductive path between the terminals.

There may be a conductive path between two terminals on the original circuit board while no conductive path can exist between two terminals corresponding to the printing device of the target series. In this case, a groove may be formed between two terminals. For example, a cutting groove formed through cutting may be configured to break off the conductive path between the two terminals so that the original circuit board added with the auxiliary part is applicable to the printing device of the target series. Multiple grooves may be disposed, ensuring that the conductive path between two or more terminals that is not to be required can be broken off.

Optionally, with continued reference to FIG. 5, the original circuit board 101 includes a first short-circuit detection terminal B 1, a ground terminal B2, and a second short-circuit detection terminal B4; the first short-circuit detection terminal B 1, the ground terminal B2, and the second short-circuit detection terminal B4 are each configured to be in contact with the printing device; the first short-circuit detection terminal B1 is configured to be electrically connected to the chip; a conductive path exists between the first short-circuit detection terminal B1 and the ground terminal B2 in the original circuit board 101; and the auxiliary part 102 includes a groove 1024 formed in the conductive path between the first short-circuit detection terminal B1 and the ground terminal B2 and configured to break off the conductive path between the first short-circuit detection terminal B1 and the ground terminal B2.

The conductive path 1013 exists between the first short-circuit detection terminal B1 and the ground terminal B2 on the original circuit board 101 so that the original circuit board 101 is applicable to the printing device of the original series. However, in the printing device of the target series, if the conductive path 1013 exists between the first short-circuit detection terminal B1 and the ground terminal B2, a detection abnormality occurs; as a result, the original circuit board 101 cannot be directly applied to the printing device of the target series. In this embodiment, the conductive path 1013 may be broken off by the groove 1024 so that the electrical connection between the first short-circuit detection terminal B1 and the ground terminal B2 is broken off, and thus the original circuit board 101 is applicable to the printing device of the target series. In this manner, the original circuit board 101 is reused.

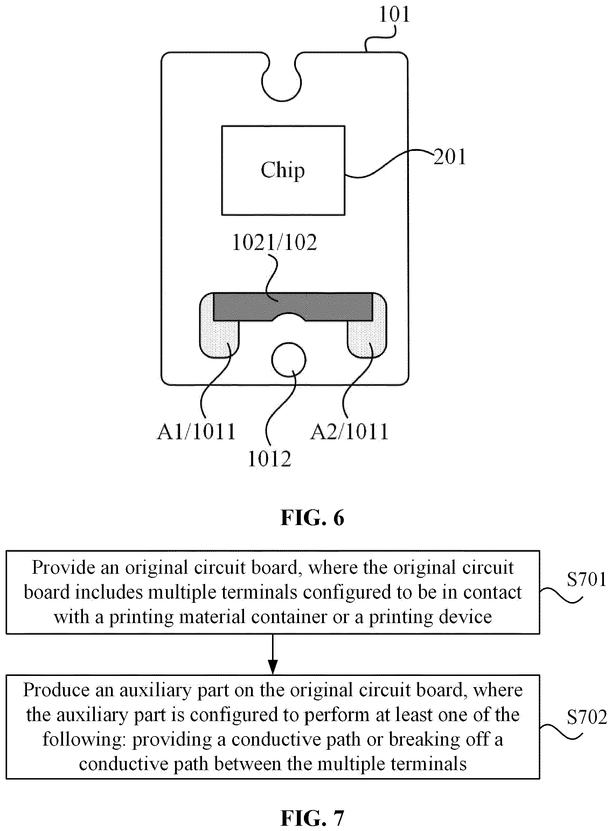

FIG. 6 is a circuit diagram of a circuit device according to an embodiment of the present application. Referring to FIG. 6, the circuit device includes the circuit board according to any embodiment of the present application and a chip 201. The chip 201 includes a control unit and a memory. Multiple pins of the chip 201 are correspondingly bonded to multiple terminals of the circuit board.

The chip 201 may include a memory configured to store related parameters (for example, the remaining ink level) in the sensor. In this embodiment, the chip 201 is disposed on the contact surface of the printing material container. In other embodiments, the chip 201 may be disposed on the contact surface of the printing device. Since the circuit device includes the circuit board according to any embodiment of the present application, the circuit device has the same effects as the circuit board according to any embodiment of the present application. The effects of the circuit device are not described here.

Optionally, at least one series-program is stored in the memory, and the control unit is configured to execute a corresponding series-program according to the type of the printing device.

The series-program may be used for the memory to communicating with the primary controller in the printing device so that the primary controller can read the information stored in the memory. Only one series-program is stored in the memory of the circuit board corresponding to the printing device of the original series. When applied to a printing device of another series, the original circuit board cannot be recognized by the printing device due to the issue of program incompatibility. In this embodiment, at least one series-program can be stored in the memory, and the control module can communicate with the primary controller in the printing device, acquire the model of the printing device, and invoke a corresponding series-program according to signals of the printing device. In this manner, the circuit board can be compatible with printing devices of more series, and the compatibility of the circuit board can be improved.

Optionally, the definition of at least one pin of the chip is different from the original definition of the corresponding terminal.

The type of the chip may be configured according to the series of the printing device. If the terminal definition of a terminal on the circuit board required by the target series is different from the terminal definition of the corresponding terminal on the original circuit board, it is feasible to change the type of the chip and the definition of the pin corresponding to the chip. If the terminal between the first short-circuit detection terminal and the power terminal on the original circuit board is a ground terminal while in the printing device of the target series the terminal corresponding to the position of the ground terminal on the original circuit board is not configured as a ground terminal, but is configured as a terminal for transmitting a clock signal, the definition of a pin of the chip may be changed, where the pin of the chip corresponding to the ground terminal on the original circuit board is changed to a pin for receiving a clock signal, so that the original circuit board and the chip are both compatible with the printing device of the target series.

An embodiment of the present application provides a printing material container assembly. The printing material container assembly includes a printing material container and the circuit device according to any embodiment of the present application. The printing material container is removably connected to the circuit device. Since the printing material container assembly includes the circuit device according to any embodiment of the present application, the printing material container assembly has the same effects as the circuit device according to any embodiment of the present application. The effects of the printing material container are not described here.

FIG. 7 is a flowchart of a production method for a circuit board according to an embodiment of the present application. Referring to FIG. 7, the method includes the steps below.

In step S701, an original circuit board is provided, where the original circuit board includes multiple terminals configured to be in contact with a printing material container or a printing device.

In step S702, an auxiliary part is produced on the original circuit board, where the auxiliary part is configured to perform at least one of the following: providing a conductive path or breaking off a conductive path between the multiple terminals.

The original circuit board may be recycled from the printing device of the original series. The original circuit board can be applied to the printing device of the target series by being provided with an auxiliary part. For the operation process of the original circuit board, reference may be made to the description of the circuit board according to any embodiment of the present application. The details are not described here.

According to the production method for a circuit board according to this embodiment, the original circuit board can be applied to the printing device of the target series, thereby improving the compatibility of the original circuit board and reducing the cost of the printing device.

Optionally, producing the auxiliary part on the original circuit board includes coating carbon oil on the circuit board. The carbon oil is configured to provide the conductive path.

The carbon oil can be easily coated on the original circuit board. The thickness of the carbon oil is small. The carbon oil is small in thickness and occupies a small space, not affecting the space occupied by the circuit board, that is, not making the circuit board change too greatly in size to match the ink cartridge or the printing device. Moreover, it is feasible to control the resistance value of the carbon oil according to the size of the carbon oil and thus to control the resistance value between corresponding terminals on the circuit board so that the printing device of the target series can recognize the circuit board made from the original circuit board.

Optionally, producing the auxiliary part on the original circuit board includes: in the case where the original circuit board includes a first sensor connection terminal and a second sensor connection terminal that are each configured to be in contact with the printing material container, producing a first auxiliary part on the original circuit board, where the first auxiliary part is connected to the first sensor connection terminal and the second sensor connection terminal and is configured to provide a conductive path between the first sensor connection terminal and the second sensor connection terminal; in the case where the original circuit board includes a first short-circuit detection terminal and a second short-circuit detection terminal that are each configured to be in contact with the printing device, producing a second auxiliary part on the original circuit board, where the second auxiliary part is connected to the first short-circuit detection terminal and the second short-circuit detection terminal and is configured to provide a conductive path between the first sensor connection terminal and the second sensor connection terminal; and in the case where the printing device includes a short-circuit detection circuit, and the original circuit board does not include a terminal configured to be electrically connected to the short-circuit detection circuit, producing a third auxiliary part on the original circuit board, where the third auxiliary part includes a contact part configured to be electrically connected to the short-circuit detection circuit.

The corresponding auxiliary part may be produced according to the type of the original circuit board. For the principle of the original circuit board, reference may be made to the description of the circuit board according to any embodiment of the present application. The details are not described here.

Optionally, producing the auxiliary part on the original circuit board includes producing a groove on the circuit board, where the groove is configured to break off the conductive path between the multiple terminals.

By way of example, the corresponding conductive path may be cut through cutting so that the electrical connection between the corresponding terminals is broken off. In this manner, the original circuit board can be applied to the printing device of the target series, and the compatibility of the original circuit board can be improved.

Optionally, in the case where the original circuit board includes a first short-circuit detection terminal, a ground terminal, and a second short-circuit detection terminal that are each configured to be in contact with the printing device, the first short-circuit detection terminal is configured to be electrically connected to a chip, and a conductive path exists between the first short-circuit detection terminal in the original circuit board and the ground terminal in the original circuit board, the groove is disposed between the first short-circuit detection terminal and the ground terminal and is configured to break off the conductive path between the first short-circuit detection terminal and the ground terminal.

The corresponding auxiliary part may be produced according to the type of the original circuit board. For the principle of the original circuit board, reference may be made to the description of the circuit board according to any embodiment of the present application. The details are not described here.

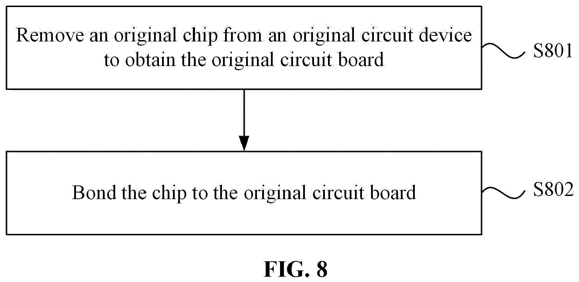

FIG. 8 is a flowchart of a production method for a circuit device according to an embodiment of the present application. Referring to FIG. 8, the production method for a circuit device is used for producing the circuit device according to any embodiment of the present application. The method includes the steps below.

In step S801, an original chip is removed from an original circuit device so that the original circuit board is obtained.

In step S802, the chip is bonded to the original circuit board.

The original circuit device may be a circuit device on the printing device of the original series. The original circuit device can be obtained by being recycled. The original circuit device includes an original circuit board and an original chip bonded to the original circuit board. The original chip may be incompatible with the printing device of the target series. It is feasible to remove the original chip and replace the original chip with a chip compatible with the printing device of the target series to make the obtained circuit device applicable to the printing device of the target series.

According to the production method for a circuit device according to this embodiment, the original circuit board can be applied to the printing device of the target series, thereby reducing the cost of the circuit device required for the printing device of the target series, thereby reducing the overall cost of the printing device.

## Claims

1. A circuit board, the circuit board being mounted on a printing material container and comprising an original circuit board and an auxiliary part, wherein the original circuit board comprises a plurality of terminals configured to be in contact with the printing material container or a printing device; and
the auxiliary part is disposed on the original circuit board and is configured to perform at least one of the following: providing a conductive path or breaking off a conductive path between the plurality of terminals.

2. The circuit board of claim 1, wherein the auxiliary part is configured to provide the conductive path, and the auxiliary part is resistive.

3. The circuit board of claim 2, wherein the auxiliary part comprises carbon oil or a resistive discrete component.

4. The circuit board of claim 3, wherein the auxiliary part is the carbon oil.

5. The circuit board of claim 4, further comprising an insulating film covering at least a portion of the auxiliary part.

6. The circuit board of claim 2, wherein the original circuit board comprises a first sensor connection terminal and a second sensor connection terminal, wherein the first sensor connection terminal and the second sensor connection terminal are each configured to be in contact with the printing material container; and
the auxiliary part comprises a first auxiliary part, wherein the first auxiliary part is connected to the first sensor connection terminal and the second sensor connection terminal and is configured to provide a conductive path between the first sensor connection terminal and the second sensor connection terminal.

7. The circuit board of claim 6, wherein the original circuit board further comprises a stop hole between the first sensor connection terminal and the second sensor connection terminal; and
a minimum distance between an edge of the first auxiliary part and an edge of the stop hole is greater than or equal to a preset distance.

8. The circuit board of claim 1, wherein the auxiliary part is only configured to provide the conductive path.

9. The circuit board of claim 8, wherein the original circuit board comprises a first short-circuit detection terminal and a second short-circuit detection terminal, wherein the first short-circuit detection terminal and the second short-circuit detection terminal are each configured to be in contact with the printing device; and
the auxiliary part comprises a second auxiliary part, wherein the second auxiliary part is connected to the first short-circuit detection terminal and the second short-circuit detection terminal and is configured to provide a conductive path between the first short-circuit detection terminal and the second short-circuit detection terminal.

10. The circuit board of claim 8, wherein the printing device comprises a short-circuit detection circuit;
the original circuit board does not comprise a terminal configured to be electrically connected to the short-circuit detection circuit; and
the auxiliary part comprises a third auxiliary part, wherein the third auxiliary part comprises a contact part configured to be electrically connected to the short-circuit detection circuit.

11. The circuit board of claim 1, wherein the auxiliary part comprises a groove configured to break off the conductive path between the plurality of terminals.

12. The circuit board of claim 11, wherein the original circuit board comprises a first short-circuit detection terminal, a ground terminal, and a second short-circuit detection terminal, wherein the first short-circuit detection terminal, the ground terminal, and the second short-circuit detection terminal are each configured to be in contact with the printing device, the first short-circuit detection terminal is configured to be electrically connected to a chip, and a conductive path exists between the first short-circuit detection terminal in the original circuit board and the ground terminal in the original circuit board; and
the groove is disposed on the conductive path between the first short-circuit detection terminal and the ground terminal and is configured to break off the conductive path between the first short-circuit detection terminal and the ground terminal.

13. A circuit device, comprising the circuit board of any one of claims 1 to 12 and a chip, wherein
the chip comprises a control unit and a memory, and a plurality of pins of the chip are correspondingly bonded to the plurality of terminals of the circuit board.

14. The circuit device of claim 13, wherein a definition of at least one pin of the plurality of pins of the chip is different from an original definition of a terminal corresponding to the at least one pin.

15. The circuit device of claim 13, wherein the memory stores at least one series-program, and the control unit is configured to execute a corresponding series-program of the at least one series-program according to a type of the printing device.

16. A printing material container assembly, comprising the circuit device of any one of claims 13 to 15 and a printing material container, wherein the printing material container is removably connected to the circuit device.

17. A production method for a circuit board, comprising:
providing an original circuit board, wherein the original circuit board comprises a plurality of terminals configured to be in contact with a printing material container or a printing device; and
producing an auxiliary part on the original circuit board, wherein the auxiliary part is configured to perform at least one of the following: providing a conductive path or breaking off a conductive path between the plurality of terminals.

18. The method of claim 17, wherein producing the auxiliary part on the original circuit board comprises:
coating carbon oil on the circuit board, wherein the carbon oil is configured to provide the conductive path.

19. The method of claim 18, wherein producing the auxiliary part on the original circuit board comprises:
in a case where the original circuit board comprises a first sensor connection terminal and a second sensor connection terminal that are each configured to be in contact with the printing material container, producing a first auxiliary part on the original circuit board, wherein the first auxiliary part is connected to the first sensor connection terminal and the second sensor connection terminal and is configured to provide a conductive path between the first sensor connection terminal and the second sensor connection terminal;
in a case where the original circuit board comprises a first short-circuit detection terminal and a second short-circuit detection terminal that are each configured to be in contact with the printing device, producing a second auxiliary part on the original circuit board, wherein the second auxiliary part is connected to the first short-circuit detection terminal and the second short-circuit detection terminal and is configured to provide a conductive path between the first sensor connection terminal and the second sensor connection terminal; and
in a case where the printing device comprises a short-circuit detection circuit, and the original circuit board does not comprise a terminal configured to be electrically connected to the short-circuit detection circuit, producing a third auxiliary part on the original circuit board, wherein the third auxiliary part comprises a contact part configured to be electrically connected to the short-circuit detection circuit.

20. The method of claim 17, wherein producing the auxiliary part on the original circuit board comprises:
producing a groove on the circuit board, wherein the groove is configured to break off the conductive path between the plurality of terminals.

21. The method of claim 20, wherein
in a case where the original circuit board comprises a first short-circuit detection terminal, a ground terminal, and a second short-circuit detection terminal that are each configured to be in contact with the printing device, the first short-circuit detection terminal is configured to be electrically connected to a chip, and a conductive path exists between the first short-circuit detection terminal in the original circuit board and the ground terminal in the original circuit board, the groove is disposed between the first short-circuit detection terminal and the ground terminal and is configured to break off the conductive path between the first short-circuit detection terminal and the ground terminal.

22. A production method for a circuit device, the method being configured to produce the circuit device of any one of claims 13 to 15 and comprising:
removing an original chip from an original circuit device to obtain the original circuit board; and
bonding the chip to the original circuit board.
